# EUROPEAN PATENT APPLICATION

(11) **EP 4 325 571 A1**
(43) Date of publication of application: **21.02.2024**
(21) Application number: 21937237.2
(22) Date of filing: 19.04.2021
(51) Int. Cl.: H01L 27/146

(54) **SEMICONDUCTOR APPARATUS AND FABRICATION METHOD THEREFOR**

(71) Applicant: Huawei Technologies Co., Ltd., Longgang Shenzhen, Guangdong 518129 (CN)
(72) Inventor: HE, Ran, Shenzhen, Guangdong 518129 (CN); JIAO, Huifang, Shenzhen, Guangdong 518129 (CN)
(74) Representative: Huawei European IPR
(86) International application number: PCT/CN2021/088066
(87) International publication number: WO 2022/221986

(57) **Abstract**

This application provides a semiconductor apparatus and a manufacturing method thereof. The semiconductor apparatus includes a first chip and a second chip, the first chip includes a first metal layer and a first bonding intermediate layer, and the second chip includes a second metal layer and a second bonding intermediate layer. The first bonding intermediate layer is provided with an opening, and the first metal layer is exposed to a surface of the first bonding intermediate layer through the opening on the first bonding intermediate layer. The second bonding intermediate layer is provided with an opening, and the second metal layer is exposed to a surface of the second bonding intermediate layer through the opening on the second bonding intermediate layer. Materials of the first bonding intermediate layer and the second bonding intermediate layer each include a material that can form a dangling bond by removing an oxide layer on the surface. According to the semiconductor apparatus provided in this application, because the first metal layer can be directly bonded with the second metal layer through a low-temperature bonding process, electrical performance of the semiconductor apparatus is improved.

## Description

### TECHNICAL FIELD

This application relates to the semiconductor field, and more specifically, to a semiconductor apparatus and a manufacturing method thereof.

### BACKGROUND

With development of a semiconductor process, an integration density requirement of an integrated circuit is increasing. A hybrid bonding technology is used to produce a three-dimensional integrated circuit (three-dimensional integrated circuit, 3DIC), and this can effectively implement a small size and high density of the integrated circuit. Usually, a process temperature of the hybrid bonding technology is 350 to 400 degrees Celsius. This limits application of the technology in the semiconductor field. A low-temperature bonding technology is crucial to extend the application of the hybrid bonding technology.

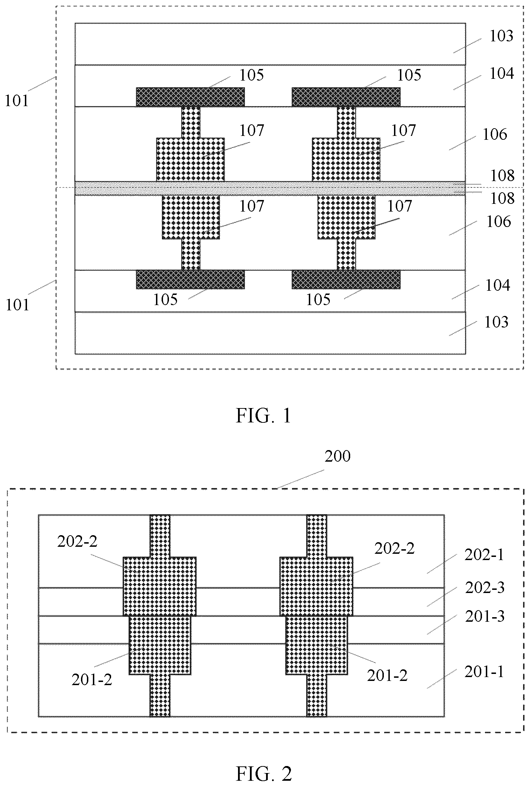

FIG. 1 is a diagram of a structure of a semiconductor apparatus produced by using a low-temperature hybrid bonding technology in the semiconductor field. As shown in FIG. 1, the semiconductor apparatus is obtained by bonding two sub-apparatuses 101. Each sub-apparatus 101 includes a semiconductor substrate 103, an insulation layer 104, a metal wiring layer 105, an insulation layer 106, and a metal layer 107. The metal layer 107 is embedded in the insulation layer 106. The insulation layer 106 and the metal layer 107 of each semiconductor apparatus are covered with a bonding intermediate layer 108. The bonding intermediate layer 108 is thin enough to exhibit non-conductivity or weak conductivity in a horizontal direction, and exhibit specific conductivity in a vertical direction. Bonding intermediate layers 108 of the two sub-apparatuses 101 may be bonded at a normal temperature after surface activation and crimping processing is performed. In this way, the two sub-apparatuses 101 are bonded, to finally obtain the semiconductor apparatus.

However, electrical performance of the semiconductor apparatus is poor. For example, a working voltage is large or power consumption is high.

### SUMMARY

This application provides a semiconductor apparatus and a manufacturing method thereof, to effectively improve electrical performance of the semiconductor apparatus.

According to a first aspect, this application provides a semiconductor apparatus, where the semiconductor apparatus includes a first chip and a second chip. The first chip includes a first bonding intermediate layer and a first metal layer, the first bonding intermediate layer is provided with an opening, and the first metal layer is exposed to a surface of the first bonding intermediate layer through the opening on the first bonding intermediate layer. The second chip includes a second bonding intermediate layer and a second metal layer, the second bonding intermediate layer is provided with an opening, and the second metal layer is exposed to a surface of the second bonding intermediate layer through the opening on the second bonding intermediate layer. Materials of the first bonding intermediate layer and the second bonding intermediate layer each include a material that can form a dangling bond by removing an oxide layer on the surface. The first bonding intermediate layer is bonded with the second bonding intermediate layer, and the first metal layer is bonded with the second metal layer.

The semiconductor apparatus provided in this application may be considered to be obtained by performing hybrid bonding on the first chip including the first metal layer and the first bonding intermediate layer and the second chip including the second metal layer and the second bonding intermediate layer. In this technical solution, for the first chip, the first bonding intermediate layer included in the first chip does not cover a surface of the first metal layer, and for a second sub-apparatus, the second bonding intermediate layer included in the second sub-apparatus does not cover a surface of the second metal layer. Therefore, when hybrid bonding is performed on the first chip and the second chip, existence of the first bonding intermediate layer and the second bonding intermediate layer does not cause a problem of a large resistance of a bonding surface after the first metal layer is bonded with the second metal layer. Therefore, electrical performance of the semiconductor apparatus can be improved.

With reference to the first aspect, in a possible implementation, the first bonding intermediate layer is located on an active surface of the first chip, and the second bonding intermediate layer is located on an active surface of the second chip.

With reference to the first aspect, in a possible implementation, a first sidewall insulation layer is disposed between the first bonding intermediate layer and the first metal layer, a second sidewall insulation layer is disposed between the second bonding intermediate layer and the second metal layer, the first sidewall insulation layer is an oxide insulation layer or a nitride insulation layer formed by the first bonding intermediate layer, and the second sidewall insulation layer is an oxide insulation layer or a nitride insulation layer formed by the second bonding intermediate layer.

In this technical solution, for each chip in the semiconductor apparatus, an oxide insulation layer or a nitride insulation layer formed by a bonding intermediate layer is included between the bonding intermediate layer and a metal layer, and the insulation layer may avoid a current leakage of the semiconductor apparatus.

With reference to the first aspect, in a possible implementation, a first isolating layer is disposed between the first metal layer and the first sidewall insulation layer, a second isolating layer is disposed between the second metal layer and the second sidewall insulation layer, and materials of the first isolating layer and the second isolating layer are insulating materials.

Compared with a semiconductor apparatus provided in a conventional technology, in this technical solution, because the first isolating layer whose material is the insulating material is added between the first metal layer of the first chip and the first sidewall insulation layer, and the second isolating layer whose material is the insulating material is added between the second metal layer of the second chip and the second sidewall insulation layer, a current leakage of the semiconductor apparatus may be further avoided.

With reference to the first aspect, in a possible implementation, the material of the first isolating layer or the second isolating layer includes any one of the following: silicon dioxide, silicon nitride, silicon oxynitride, silicon carbon nitride, aluminum oxide, and silicon oxycarbide.

With reference to the first aspect, in a possible implementation, the semiconductor apparatus further includes a first insulation layer, a second insulation layer, a third insulation layer, a fourth insulation layer, a first metal wiring layer, a second metal wiring layer, a first diffusion barrier layer, and a second diffusion barrier layer. The first metal wiring layer is located in a groove of the third insulation layer, the first insulation layer covers a surface of the third insulation layer and covers one part of a surface of the first metal wiring layer, and the diffusion barrier layer is disposed on the other part of the surface of the first metal wiring layer, disposed between the first insulation layer and the first metal layer, and disposed between the first metal layer and the first isolating layer. The second metal wiring layer is located in a groove of the fourth insulation layer, the second insulation layer covers a surface of the fourth insulation layer and covers one part of a surface of the second metal wiring layer, and the diffusion barrier layer is disposed on the other part of the surface of the second metal wiring layer, disposed between the second insulation layer and the second metal layer, and disposed between the second metal layer and the second isolating layer.

With reference to the first aspect, in a possible implementation, the semiconductor apparatus further includes a first semiconductor substrate and a second semiconductor substrate, the third insulation layer covers a surface of the first semiconductor substrate, and the fourth insulation layer covers a surface of the second semiconductor substrate.

With reference to the first aspect, in a possible implementation, thicknesses of the first bonding intermediate layer and the second bonding intermediate layer fall within a range of 5 nanometers to 500 nanometers.

With reference to the first aspect, in a possible implementation, the material of the first bonding intermediate layer or the second bonding intermediate layer includes any one of the following: silicon, germanium, silicon carbide, and aluminum nitride.

According to a second aspect, this application provides a semiconductor apparatus, where the semiconductor apparatus includes a first chip and a second chip.

The first chip includes a first bonding intermediate layer and a first metal layer, the first bonding intermediate layer is provided with an opening, and the first metal layer is exposed to a surface of the first bonding intermediate layer through the opening on the first bonding intermediate layer. The second chip includes a second bonding intermediate layer and a second metal layer, the second bonding intermediate layer is provided with an opening, and the second metal layer is exposed to a surface of the second bonding intermediate layer through the opening on the second bonding intermediate layer. Materials of the first bonding intermediate layer and the second bonding intermediate layer each include any one of the following: silicon, silicon carbide, aluminum nitride, and germanium. The first bonding intermediate layer is bonded with the second bonding intermediate layer, and the first metal layer is bonded with the second metal layer.

According to a third aspect, this application provides a semiconductor apparatus manufacturing method, including: performing surface activation processing on a first surface of a first chip in a vacuum environment, where the first chip includes a first insulation layer, a first metal layer, and a first bonding intermediate layer, the first metal layer is located in a groove of the first insulation layer, the first bonding intermediate layer covers a surface of the first insulation layer, the first bonding intermediate layer is provided with an opening, the first metal layer is exposed to a surface of the first bonding intermediate layer through the opening on the first bonding intermediate layer, a material of the first bonding intermediate layer includes a material that can form a dangling bond by removing an oxide layer on the surface, the first surface includes an exposed surface of the first bonding intermediate layer and an exposed surface of the first metal layer, and the surface activation processing includes removing an oxide layer on the surface of the first metal layer and an oxide layer on the surface of the first bonding intermediate layer; performing surface activation processing on a second surface of a second chip in the vacuum environment, where the second chip includes a second insulation layer, a second metal layer, and a second bonding intermediate layer, the second metal layer is located in a groove of the second insulation layer, the second bonding intermediate layer covers a surface of the second insulation layer, the second bonding intermediate layer is provided with an opening, the second metal layer is exposed to a surface of the second bonding intermediate layer through the opening on the second bonding intermediate layer, a material of the second bonding intermediate layer includes a material that can form a dangling bond by removing an oxide layer on the surface, the second surface includes an exposed surface of the second bonding intermediate layer and an exposed surface of the second metal layer, and the surface activation processing includes removing an oxide layer on the surface of the second metal layer and an oxide layer on the surface of the second bonding intermediate layer; aligning, with the second surface on which surface activation processing has been performed and that is of the second chip, the first surface on which surface activation processing has been performed and that is of the first chip; and applying pressure to the first chip and the second chip, to enable the first metal layer to be bonded with the second metal layer, and enable the first bonding intermediate layer to be bonded with the second bonding intermediate layer.

With reference to the third aspect, in a possible implementation, before the performing surface activation processing on a first surface of a first chip in a vacuum environment, the method further includes: manufacturing the first bonding intermediate layer on the surface of the first insulation layer of a first initial apparatus; manufacturing a groove on the first bonding intermediate layer and the first insulation layer; manufacturing the first metal layer in the groove; and removing all layers on the first bonding intermediate layer to expose the surface of the first bonding intermediate layer, to obtain the first chip.

With reference to the third aspect, in a possible implementation, before the manufacturing the first metal layer in the groove, the method further includes: forming a first sidewall insulation layer on the surface of the first bonding intermediate layer and between the first bonding intermediate layer and the first metal layer.

With reference to the third aspect, in a possible implementation, the exposed surface of the first metal layer is higher than the exposed surface of the first bonding intermediate layer.

With reference to the third aspect, in a possible implementation, the manufacturing a groove on the first bonding intermediate layer and the first insulation layer includes: manufacturing a first groove on the first bonding intermediate layer, where a depth of the first groove is equal to or greater than a thickness of the first bonding intermediate layer; manufacturing a first isolating layer on a surface of the first groove; opening a bottom surface of the first groove; and manufacturing a second groove in the first insulation layer.

With reference to the third aspect, in a possible implementation, the first initial apparatus further includes a third insulation layer and a first metal wiring layer, the first metal wiring layer is located in a groove of the third insulation layer, and the first insulation layer covers the third insulation layer and the first metal wiring layer. The second groove manufactured in the first insulation layer penetrates the first insulation layer, and the first metal wiring layer is exposed.

With reference to the third aspect, in a possible implementation, before the manufacturing the first metal layer in the groove, the method further includes: manufacturing a diffusion barrier layer on the surface of the first groove and a surface of the second groove.

With reference to the third aspect, in a possible implementation, the material of the first bonding intermediate layer or the second bonding intermediate layer includes any one of the following: silicon, silicon carbide, germanium, and aluminum nitride.

### BRIEF DESCRIPTION OF DRAWINGS

FIG. 1 is a schematic diagram of a structure of a semiconductor apparatus in a conventional technology according to an embodiment of this application;
FIG. 2 is a schematic diagram of a structure of a semiconductor apparatus according to an embodiment of this application;
FIG. 3 is a schematic diagram of a structure of a semiconductor apparatus according to another embodiment of this application;
FIG. 4 is a schematic diagram of a structure of a semiconductor apparatus before hybrid bonding according to an embodiment of this application;
FIG. 5 is a schematic diagram of a structure of a semiconductor apparatus before hybrid bonding according to another embodiment of this application;
FIG. 6 is a schematic diagram of a structure of a semiconductor apparatus before hybrid bonding according to still another embodiment of this application;
FIG. 7A and FIG. 7B are a schematic flowchart of a semiconductor apparatus manufacturing method according to an embodiment of this application;
FIG. 8 is a schematic diagram of a structure of a first initial apparatus according to an embodiment of this application;
FIG. 9 is a schematic diagram of a structure of a first chip obtained after a bonding intermediate layer is manufactured according to an embodiment of this application;
FIG. 10 is a schematic diagram of a structure of a first chip obtained after a first groove is manufactured according to an embodiment of this application;
FIG. 11 is a schematic diagram of a structure of a first chip obtained after a first sidewall insulation layer is formed according to an embodiment of this application;
FIG. 12 is a schematic diagram of a structure of a first chip obtained after a first isolating layer is manufactured according to an embodiment of this application;
FIG. 13 is a schematic diagram of a structure of a first chip obtained after a second groove is manufactured according to an embodiment of this application;
FIG. 14 is a schematic diagram of a structure of an apparatus obtained after a first diffusion barrier layer and a first metal layer are manufactured according to an embodiment of this application;
FIG. 15 is a schematic diagram of a structure of a first chip obtained after all layers on a first bonding intermediate layer are removed according to an embodiment of this application;
FIG. 16 is a schematic diagram of a structure of a first chip obtained after both a first sidewall insulation layer and an opening are formed according to an embodiment of this application;
FIG. 17 is a schematic diagram of a structure of a first chip obtained after all layers on a first bonding intermediate layer are removed according to another embodiment of this application;
FIG. 18 is a schematic diagram of performing surface activation on a native oxide layer on a surface of a first chip according to an embodiment of this application;
FIG. 19 is a schematic diagram of a structure of aligning a first surface with a second surface according to an embodiment of this application;
FIG. 20 is a schematic diagram of a structure in which a first metal layer is first bonded with a second metal layer according to an embodiment of this application;
FIG. 21 is a schematic diagram of a structure of in which a first bonding intermediate layer is first bonded with a second bonding intermediate layer according to another embodiment of this application; and
FIG. 22 is a schematic diagram of a structure of a semiconductor apparatus after hybrid bonding according to an embodiment of this application.

### DESCRIPTION OF EMBODIMENTS

To better understand technical solutions in embodiments of this application, the following first describes some concepts used in embodiments of this application.

### 1. Bonding

Bonding is a technology in which after surface cleaning and activation processing is performed, two homogeneous or heterogeneous semiconductor materials with clean surfaces and atomic-level flatness are directly combined under a specific condition, and wafers are integrally bonded by using Van der Waals force, molecular force, or even atomic force.

Surface activated bonding (surface activated bonding, SAB) is used as a manner that can implement bonding, and a basic principle is that in a vacuum environment, a high-speed argon atom or argon ion is used to bombard a surface of a solid-state material, remove an oxide film and a contaminant of the oxide film on the surface, and form a dangling bond on the surface of the material. Then, specific pressure is applied, to enable two surfaces on which oxide films have been removed to be in close contact in a high vacuum environment. Surface energy is reduced by using inter-atomic force, to implement solid combining on an atomic scale. Good bonding strength can be achieved at a room temperature, and no subsequent annealing is required, thereby eliminating a thermal stress problem caused by mismatch of a coefficient of thermal expansion.

The development of a surface activated bonding method mainly starts in the 1990s, and has implemented high-strength and normal-temperature bonding between a plurality of types of metals, between a metal and a ceramic, and between a semiconductor and a semiconductor material. However, for some insulation layer materials, such as silicon dioxide and silicon nitride, the surface activated bonding method does not implement high-strength bonding. In addition, because activity of the surface on which ion beam bombardment has been performed is extremely high, if the process is performed in a non-ideal state, a problem of secondary oxidation or secondary pollution is likely to occur. Therefore, a bombardment process and a bonding process are usually performed in a vacuum environment.

### 2. Wafer

A wafer is a semiconductor wafer used for manufacturing a semiconductor integrated circuit, and the most common raw material is silicon. High-purity polycrystalline silicon dissolves and then is doped into a silicon crystal, and then slowly pulled out to form cylindrical monocrystalline silicon. After grinding, polishing, and slicing, a silicon ingot forms a silicon wafer, namely, a wafer.

To make the objectives and technical solutions of this application clearer and more intuitive, the following describes, in detail with reference to the accompanying drawings and embodiments, a semiconductor apparatus and a manufacturing method thereof that are provided in this application. It should be understood that specific embodiments described herein are merely used to explain this application but are not intended to limit this application.

It is found through analysis of a semiconductor apparatus in a conventional technology that, a reason why a surface resistance of the semiconductor apparatus is large is that conductivity of a bonding intermediate layer 108 is between an insulating material and a metal material. Therefore, if two sub-apparatuses are bonded completely by using the bonding intermediate layer 108, a resistance between metal layers increases. Consequently, electrical performance of the semiconductor apparatus obtained through bonding is affected. For example, a voltage required by the semiconductor apparatus is large and power consumption is high. In addition, because the bonding intermediate layer 108 is a non-ideal insulating material, a current leakage of the semiconductor apparatus may further be caused.

To resolve the foregoing problem, this application provides a new semiconductor apparatus and a semiconductor apparatus manufacturing method, to avoid a problem that a resistance of a bonding surface of the semiconductor apparatus is large. In this way, electrical performance of the semiconductor apparatus can be improved. Further, the semiconductor apparatus provided in this application can avoid a current leakage. It is noted herein that, in embodiments of this application, the bonding surface of the semiconductor apparatus may also be referred to as a bonding surface.

FIG. 2 is a schematic diagram of a structure of a semiconductor apparatus 200 according to an embodiment of this application. As shown in FIG. 2, the semiconductor apparatus 200 provided in this embodiment of this application includes: a first insulation layer 201-1, a first metal layer 201-2, a first bonding intermediate layer 201-3, a second insulation layer 202-1, a second metal layer 202-2, and a second bonding intermediate layer 202-3.

The first insulation layer 201-1, the first metal layer 201-2, and the first bonding intermediate layer 201-3 may be considered as parts included in a first chip, and the second insulation layer 202-1, the second metal layer 202-2, and the second bonding intermediate layer 202-3 may be considered as parts included in a second chip. In this application, the first chip is also referred to as a first sub-apparatus, and the second chip is also referred to as a second sub-apparatus.

Materials of the first bonding intermediate layer 201-3 and the second bonding intermediate layer 202-3 each are a material that can form a dangling bond by removing an oxide layer on a surface. The material of the bonding intermediate layer may exhibit specific conductivity or non-conductivity. For example, the material may be silicon, germanium, silicon carbide, or aluminum nitride. This is not limited in this embodiment of this application.

The first metal layer 201-2 is located in a groove of the first insulation layer 201-1, and the second metal layer 202-2 is located in a groove of the second insulation layer 202-1. The first bonding intermediate layer 201-3 covers a surface of the first insulation layer 201-1, the first bonding intermediate layer 201-3 is provided with an opening, and a surface of the first metal layer 201-2 is exposed to the surface of the first bonding intermediate layer 201-3 through the opening. That is, a surface of the first chip includes the surface of the first metal layer 201-2 and the surface of the first bonding intermediate layer 201-3.

The second bonding intermediate layer 202-3 covers a surface of the second insulation layer 202-1, the second bonding intermediate layer 202-3 is provided with an opening, and a surface of the second metal layer 202-2 is exposed to the surface of the second bonding intermediate layer 202-3 through the opening. That is, a surface of the second chip includes the surface of the second metal layer 202-2 and the surface of the second bonding intermediate layer 202-3.

The first bonding intermediate layer 201-3 is bonded with the second bonding intermediate layer 202-3, and the first metal layer 201-2 is bonded with the second metal layer 202-2.

In this embodiment, materials of the first insulation layer 201-1 and the second insulation layer 202-1 are insulating materials. For example, the material may be formed by an oxide or a nitride of a semiconductor substrate material. This is not limited in this embodiment of this application. In an example, when the semiconductor substrate material is monocrystalline silicon, the first insulation layer 201-1 and the second insulation layer 202-1 may form a silicon oxide film and a silicon nitride film by using an oxidation furnace, a nitriding furnace, a chemical vapor deposition (chemical vapor deposition, CVD) apparatus, or the like.

The first metal layer 201-2 and the second metal layer 202-2 may be made of a material with excellent conductivity performance. For example, the material may be copper. This is not limited in this embodiment of this application. An electronic circuit in the semiconductor apparatus 200 may be formed by connecting the first metal layer 201-2 and the second metal layer 202-2. For details, refer to descriptions in a related embodiment. Details are not described herein.

In this embodiment, the first bonding intermediate layer 201-3 is located on the first insulation layer 201-1, covers only the surface of the first insulation layer 201-1, and does not cover the surface of the first metal layer 201-2. The second bonding intermediate layer 202-3 is located on the second insulation layer 202-1, covers only the surface of the second insulation layer 202-1, and does not cover the surface of the second metal layer 202-2.

Optionally, thicknesses of the first bonding intermediate layer 201-3 and the second bonding intermediate layer 202-3 may fall within a range of 5 nanometers to 500 nanometers.

The semiconductor apparatus provided in this application may be considered to be obtained by performing hybrid bonding on the first chip including the first insulation layer 201-1, the first metal layer 201-2, and the first bonding intermediate layer 201-3 and the second chip including the second insulation layer 202-1, the second metal layer 202-2, and the second bonding intermediate layer 202-3. In this technical solution, for the first chip, the first bonding intermediate layer 201-3 included in the first chip does not cover the surface of the first metal layer 201-2, and for the second sub-apparatus, the second bonding intermediate layer 202-3 included in the second sub-apparatus does not cover the surface of the second metal layer 202-2. Therefore, when hybrid bonding is performed on the first chip and the second chip, existence of the first bonding intermediate layer 201-3 and the second bonding intermediate layer 202-3 does not cause a problem of a large resistance of a bonding surface after the first metal layer 201-2 is bonded with the second metal layer 202-2. Therefore, electrical performance of the semiconductor apparatus can be improved.

In a possible implementation, the first bonding intermediate layer 201-3 is located on an active surface of the first chip, and the second bonding intermediate layer 202-3 is located on an active surface of the second chip. For related descriptions of the active surface of the chip, refer to a related technology. Details are not described herein.

It is noted herein that in the semiconductor apparatus shown in FIG. 2, only two first metal layers 201-2 located in the groove of the first insulation layer 201-1 and two second metal layers 202-2 located in the groove of the second insulation layer 202-1 are provided as an example. In this embodiment, a quantity of first metal layers 201-2 located in the groove of the first insulation layer 201-1 and a quantity of second metal layers 202-2 located in the groove of the second insulation layer 202-1 in the semiconductor apparatus are not limited.

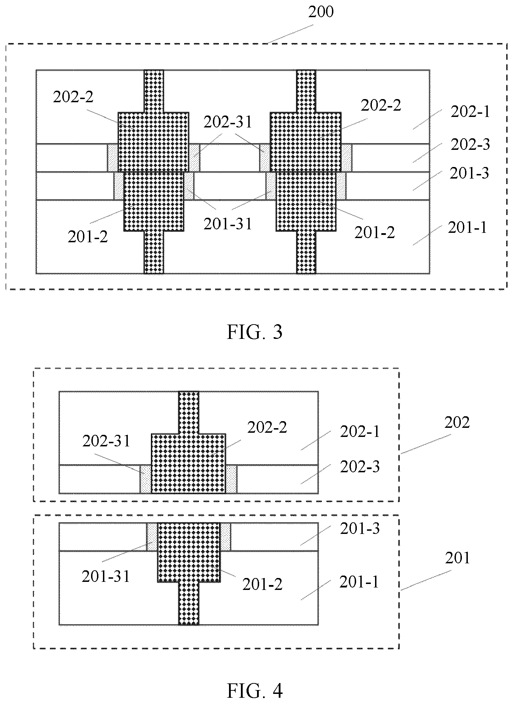

FIG. 3 is a schematic diagram of a structure of a semiconductor apparatus 200 according to another embodiment of this application. As shown in FIG. 3, a difference between this embodiment and the embodiment shown in FIG. 2 lies in that, a first sidewall insulation layer 201-31 is disposed between a first bonding intermediate layer 201-3 and a first metal layer 201-2, a second sidewall insulation layer 202-31 is disposed between a second bonding intermediate layer 202-3 and a second metal layer 202-2. The first sidewall insulation layer 201-31 is an oxide insulation layer or a nitride insulation layer formed by the first bonding intermediate layer 201-3, and the second sidewall insulation layer 202-31 is an oxide insulation layer or a nitride insulation layer formed by the second bonding intermediate layer 202-3.

It may be understood that, in an actual environment, formation of a native oxide cannot be avoided. Therefore, in this embodiment, the first sidewall insulation layer 201-31 is further included between the first bonding intermediate layer 201-3 and the first metal layer 201-2, and the second sidewall insulation layer 202-31 is further included between the second bonding intermediate layer 202-3 and the second metal layer 202-2.

In a possible implementation, the first sidewall insulation layer 201-31 is used as an example. The first sidewall insulation layer 201-31 may be an insulation layer formed by exposing the first bonding intermediate layer 201-3 to the air, or may be an insulation layer formed by using another process method (for example, oxygen ion processing or nitrogen ion processing). This is not limited in this embodiment of this application.

It may be further understood that, for each sub-apparatus in the semiconductor apparatus, because the oxide insulation layer or the nitride insulation layer formed by the bonding intermediate layer is included between the bonding intermediate layer and the metal layer, a current leakage of the semiconductor apparatus may be reduced through the insulation layer.

To describe the schematic diagram of a structure of the semiconductor apparatus in this embodiment more clearly, FIG. 4 is a schematic diagram of a structure of the semiconductor apparatus shown in FIG. 3 before hybrid bonding.

As shown in FIG. 4, the semiconductor apparatus 200 may be obtained by bonding a first sub-apparatus 201 with a second sub-apparatus 202. The first sub-apparatus 201 includes a first insulation layer 201-1, a first metal layer 201-2, a first bonding intermediate layer 201-3, and a first sidewall insulation layer 201-31. The second sub-apparatus 202 includes a second insulation layer 202-1, a second metal layer 202-2, a second bonding intermediate layer 202-3, and a second sidewall insulation layer 202-31.

It can be more clearly seen from FIG. 4 that, the first bonding intermediate layer 201-3 in the first sub-apparatus covers only a surface of the first insulation layer 201-1, and does not cover a surface of the first metal layer 201-2, and the second bonding intermediate layer 202-3 in the second sub-apparatus covers only a surface of the second insulation layer 202-1, and does not cover a surface of the second metal layer 202-2. Because of such structures as the first sub-apparatus and the second sub-apparatus, after bonding processing is performed on the first sub-apparatus and the second sub-apparatus, the first metal layer 201-2 may be directly bonded with the second metal layer 202-2, thereby avoiding a problem that a resistance between the first metal layer 201-2 and the second metal layer 202-2 is large because of the bonding intermediate layer.

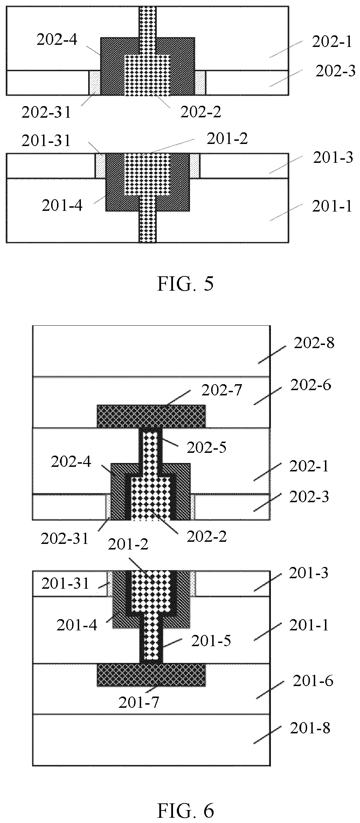

In some implementations, the first bonding intermediate layer 201-3 and the second bonding intermediate layer 202-3 may be made of non-ideal insulating materials, and this may cause a problem of a current leakage of the bonding intermediate layer in the semiconductor apparatus obtained through bonding. To resolve this problem, as shown in FIG. 5, a first isolating layer 201-4 is disposed between the first metal layer 201-2 and the first sidewall insulation layer 201-31, a second isolating layer 202-4 is disposed between the second metal layer 202-2 and the second sidewall insulation layer 202-31, and both materials of the first isolating layer 201-4 and the second isolating layer 202-4 are insulating materials.

For example, the materials of the first isolating layer 201-4 and the second isolating layer 202-4 may include any one of the following: silicon dioxide, silicon nitride, silicon carbon nitride, aluminum oxide, and silicon oxycarbide. This is not limited in this embodiment of this application.

It may be understood that each sub-apparatus that constitutes the semiconductor apparatus in this application may further include more structures, and correspondingly, the semiconductor apparatus may further include more structures.

For example, as shown in FIG. 6, the semiconductor apparatus 200 may further include a third insulation layer 201-6, a fourth insulation layer 202-6, a first metal wiring layer 201-7, a second metal wiring layer 202-7, a first diffusion barrier layer 201-5, and a second diffusion barrier layer 201-5.

The first metal wiring layer 201-7 is located in a groove of the third insulation layer 201-6, the first insulation layer 201-1 covers a surface of the third insulation layer 201-6 and covers one part of a surface of the first metal wiring layer 201-7, and the diffusion barrier layer 201-5 is disposed on the other part of the surface of the first metal wiring layer 201-7, disposed between the first insulation layer 201-1 and the first metal layer 201-2, and disposed between the first metal layer 201-2 and the first isolating layer 201-4. The second metal wiring layer 202-7 is located in a groove of the fourth insulation layer 202-6, the second insulation layer 202-1 covers a surface of the fourth insulation layer 202-6 and covers one part of a surface of the second metal wiring layer 202-7, and the diffusion barrier layer 202-5 is disposed on the other part of the surface of the second metal wiring layer 202-7, disposed between the second insulation layer 202-1 and the second metal layer 202-2, and disposed between the second metal layer 202-2 and the second isolating layer 202-4.

As shown in FIG. 6, the semiconductor apparatus further includes a first semiconductor substrate 201-8 and a second semiconductor substrate 202-8, the third insulation layer 201-6 covers a surface of the first semiconductor substrate 201-8, and the fourth insulation layer 202-6 covers a surface of the second semiconductor substrate 202-8.

For example, the first semiconductor substrate 201-8 and the second semiconductor substrate 202-8 may be wafers, and may also be substances made of materials such as germanium, gallium arsenide, or silicon carbide. In addition, the first semiconductor substrate 201-8 and the second semiconductor substrate 202-8 may use a same material, or may use different materials. This is not limited in this embodiment of this application.

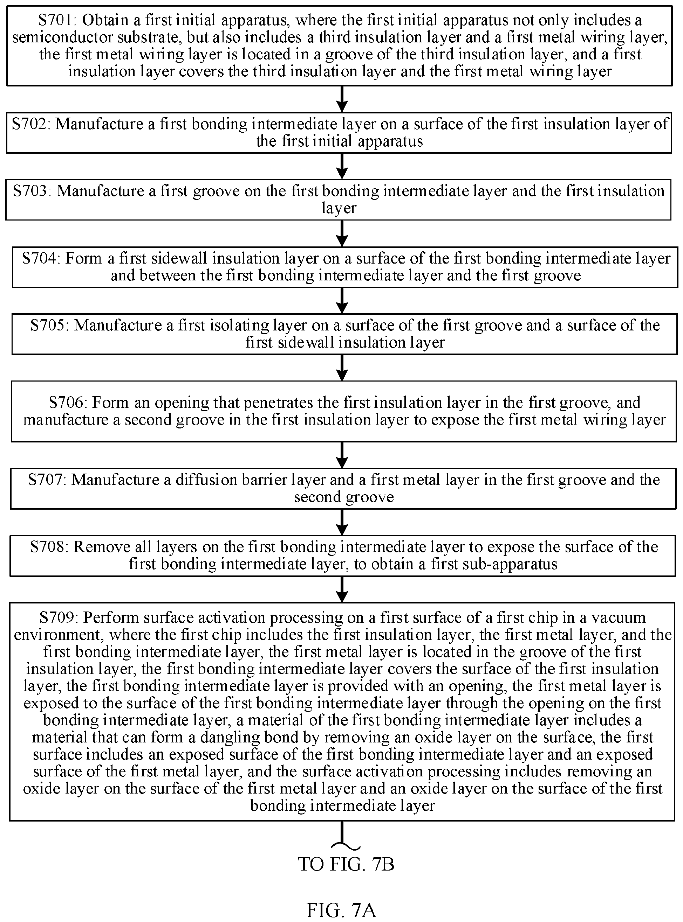

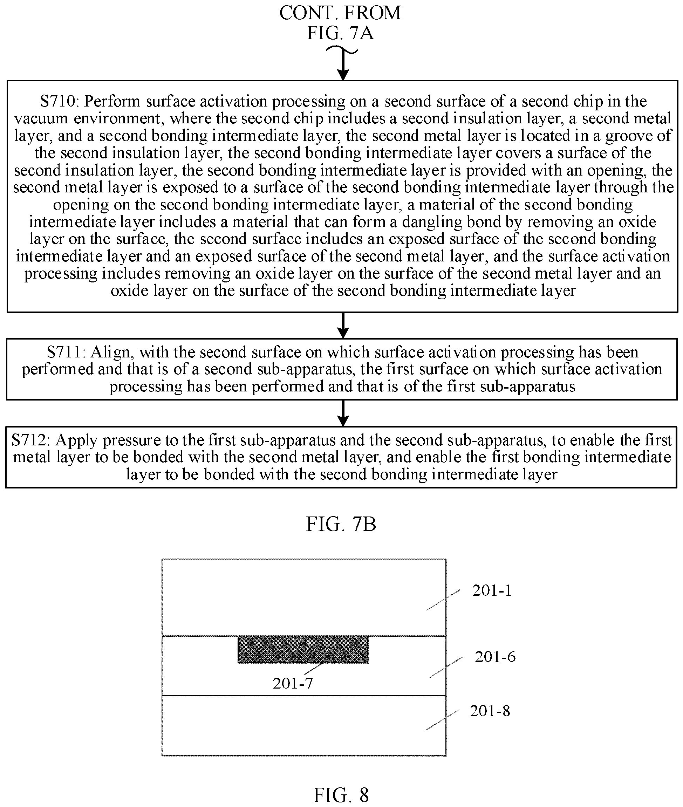

The following describes a semiconductor apparatus manufacturing method according to an embodiment of this application with reference to FIG. 7A and FIG. 7B. It may be understood that the manufacturing manner shown in FIG. 7A and FIG. 7B is merely an example, and should not constitute a limitation on this application.

As shown in FIG. 7A and FIG. 7B, the method in this embodiment may include S701, S702, S703, S704, S705, S706, S707, S708, S709, S710, S711, and S712.

S701: Obtain a first initial apparatus, where the first initial apparatus not only includes a semiconductor substrate 201-8, but also includes a third insulation layer 201-6 and a first metal wiring layer 201-7, the first metal wiring layer 201-7 is located in a groove of the third insulation layer 201-6, and a first insulation layer 201-1 covers the third insulation layer 201-6 and the first metal wiring layer 201-7.

For example, the semiconductor substrate 201-8 may be a wafer.

An exemplary diagram of the structure of the first initial apparatus is shown in FIG. 8.

It is noted herein that in the first initial apparatus shown in FIG. 8, there may be one or more third insulation layers 201-6 and one or more first metal wiring layers 201-7. This is not limited in this embodiment of this application.

S702: Manufacture a first bonding intermediate layer 201-3 on a surface of the first insulation layer 201-1 of the first initial apparatus.

In this embodiment, a material of the first bonding intermediate layer 201-3 is a material that can be directly formed by using a dangling bond on a surface of the first bonding intermediate layer 201-3, and includes but is not limited to: silicon, germanium, silicon carbide, and aluminum nitride. A thickness of the first bonding intermediate layer 201-3 may fall within a range of 5 nanometers to 500 nanometers.

Further, a material with high thermal conductivity may be used as the material of the first bonding intermediate layer 201-3, to reduce an inter-layer thermal resistance. For example, thermal conductivity of silicon carbide is greater than that of aluminum nitride, thermal conductivity of aluminum nitride is greater than that of silicon, and thermal conductivity of silicon is greater than that of silicon dioxide.

For the first insulation layer 201-1, refer to descriptions in the foregoing embodiment. Details are not described herein again.

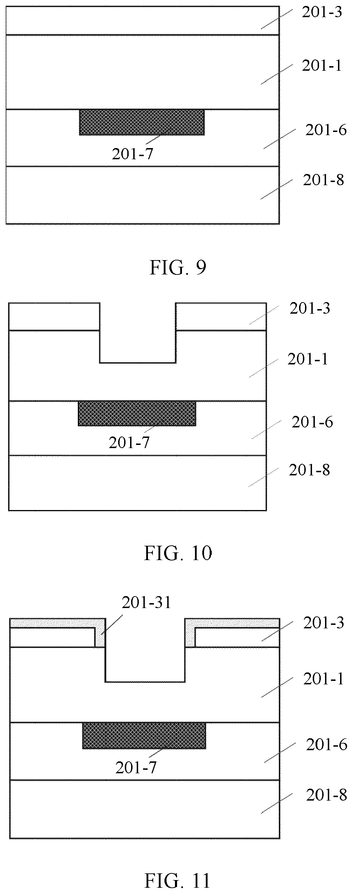

An exemplary diagram of a structure obtained after the first bonding intermediate layer 201-3 is manufactured on the surface of the first insulation layer 201-1 of the first initial apparatus is shown in FIG. 9.

S703: Manufacture a first groove on the first bonding intermediate layer 201-3 and the first insulation layer 201-1.

A method for forming the first groove may include etching, and a depth of the first groove may be equal to or greater than the thickness of the first bonding intermediate layer 201-3.

An exemplary diagram of a structure obtained after the first groove is manufactured on the first bonding intermediate layer 201-3 and the first insulation layer 201-1 is shown in FIG. 10.

S704: Form a first sidewall insulation layer 201-31 on the surface of the first bonding intermediate layer 201-3 and between the first bonding intermediate layer 201-3 and the first groove.

For detailed descriptions of the first sidewall insulation layer 201-31, refer to descriptions in the foregoing embodiment. Details are not described herein again.

FIG. 11 shows the first sidewall insulation layer 201-31 formed on the surface of the first bonding intermediate layer 201-3 and between the first bonding intermediate layer 201-3 and the first groove.

S705: Manufacture a first isolating layer 201-4 on a surface of the first groove and a surface of the first sidewall insulation layer 201-31.

A material of the first isolating layer 201-4 is an insulating material, and includes but is not limited to: silicon dioxide, silicon nitride, silicon carbon nitride, aluminum oxide, and silicon oxycarbide.

In a possible implementation, the layer may be manufactured by using chemical vapor deposition. For specific descriptions, refer to an implementation process in a related technology.

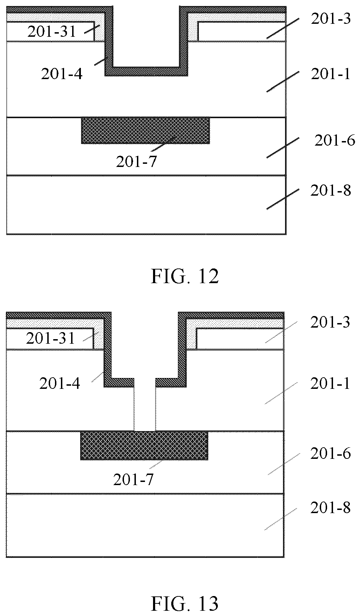

An exemplary of a structure obtained after the first isolating layer 201-4 is manufactured on the surface of the first groove and the surface of the first sidewall insulation layer 201-31 is shown in FIG. 12.

S706: Form an opening that penetrates the first insulation layer 201-1 in the first groove, and manufacture a second groove in the first insulation layer 201-1 to expose the first metal wiring layer 201-7.

An exemplary diagram of a structure obtained after the opening that penetrates the first insulation layer 201-1 is formed in the first groove, and the second groove is manufactured in the first insulation layer 201-1 is shown in FIG. 13.

S707: Manufacture a first diffusion barrier layer 201-5 and a first metal layer 201-2 in the first groove and the second groove.

A material of the first diffusion barrier layer 201-5 includes but is not limited to titanium, tantalum, titanium nitride, and tantalum nitride. A method for manufacturing the layer may be physical vapor deposition, a material of the first metal layer 201-2 may be copper, and the manufacturing method is, for example, electroplating. For specific descriptions thereof, refer to descriptions in a related embodiment. Details are not described herein again.

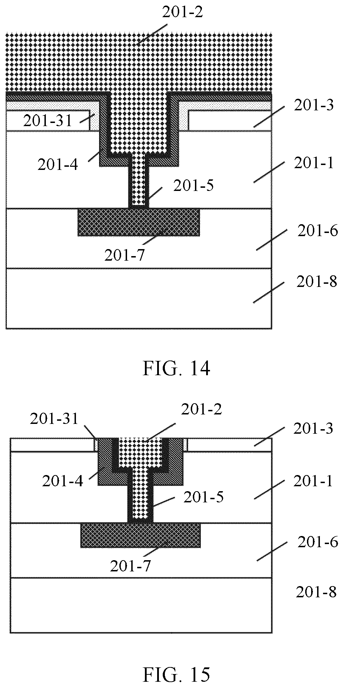

An exemplary diagram of a structure obtained after the first diffusion barrier layer 201-5 and the first metal layer 201-2 are manufactured in the first groove and the second groove is shown in FIG. 14.

S708: Remove all layers on the first bonding intermediate layer 201-3 to expose the surface of the first bonding intermediate layer 201-3, to obtain a first chip.

All the layers include the first diffusion barrier layer 201-5, the first metal layer 201-2, and the first isolating layer 201-4. In an implementation, a height difference between the surface of the first bonding intermediate layer 201-3 and a surface of the first metal layer 201-2 may be within 10 nanometers or -10 nanometers through adjustment of a chemical mechanical polishing process. For specific descriptions, refer to descriptions in a related technology. Details are not described herein again.

An exemplary diagram of a structure obtained after all the layers on the first bonding intermediate layer 201-3 are removed is shown in FIG. 15.

It is noted herein that, S701 to S708 are merely an example of obtaining the first chip, and the first chip in embodiments of this application may alternatively not include the first isolating layer 201-4 (that is, step S705 is not performed).

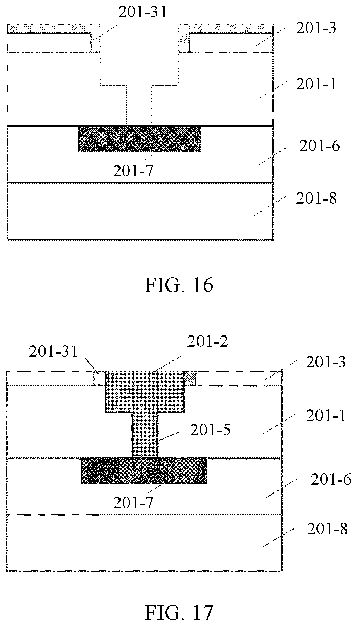

For example, when the first chip does not include the first isolating layer 201-4, as shown in FIG. 16, the first sidewall insulation layer 201-31 may be formed on the surface of the first bonding intermediate layer 201-3 and between the first bonding intermediate layer 201-3 and the first groove (that is, step S704), and S706 is performed at the same time. Then, S707 and S708 are performed, and a finally obtained first chip is shown in FIG. 17.

It is further noted herein that there is no sequence of steps S701 to S708. For example, S706 may be performed first after the first sidewall insulation layer 201-31 is formed in step S704, S705 is then performed to form the first isolating layer 201-4, and then the first isolating layer 201-4 on a surface of the second groove is removed.

It may be understood that, because a second chip and the first chip have a same structure, a manufacturing process of the second chip may be similar to the method in this embodiment. Details are not described herein again.

After the first chip and the second chip are obtained by performing S701 to S708, hybrid bonding may be performed on the first chip and the second chip, to obtain the semiconductor apparatus.

The following describes, with reference to S709 to S711, a hybrid bonding method provided in embodiments of this application.

S709: Perform surface activation processing on a first surface of a first chip in a vacuum environment, where the first chip includes a first insulation layer, a first metal layer, and a first bonding intermediate layer. The first metal layer is located in a groove of the first insulation layer, the first bonding intermediate layer covers a surface of the first insulation layer, the first bonding intermediate layer is provided with an opening, and the first metal layer is exposed to a surface of the first bonding intermediate layer through the opening on the first bonding intermediate layer. A material of the first bonding intermediate layer includes a material that can form a dangling bond by removing an oxide layer on the surface, and the first surface includes an exposed surface of the first bonding intermediate layer and an exposed surface of the first metal layer. The surface activation processing includes removing an oxide layer on the surface of the first metal layer and an oxide layer on the surface of the first bonding intermediate layer.

In this embodiment, the exposed surface of the first bonding intermediate layer 201-3 and the exposed surface of the first metal layer 201-2 represent the first surface, and are used to perform hybrid bonding with a second chip.

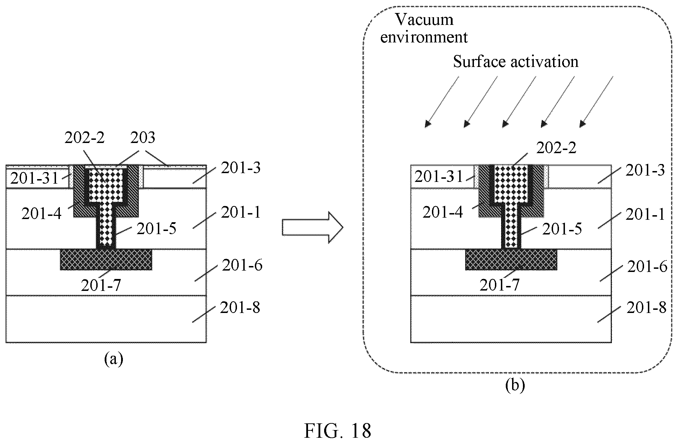

In an actual environment, the exposed surface of the first bonding intermediate layer 201-3 and the exposed surface of the first metal layer 201-2 easily form a native oxide layer. As shown in (a) in FIG. 18, the surface of the first chip covers a native oxide layer 203.

Therefore, in this embodiment, surface activation processing is performed on the first surface in the vacuum environment, as shown in (b) in FIG. 18, to remove the native oxide layer 203 on the surfaces of the first bonding intermediate layer 201-3 and the first metal layer 201-2.

For the first chip and the second chip, refer to specific descriptions in the foregoing embodiment. Details are not described herein again.

S710: Perform surface activation processing on a second surface of the second chip in the vacuum environment, where the second chip includes a second insulation layer, a second metal layer, and a second bonding intermediate layer. The second metal layer is located in a groove of the second insulation layer, the second bonding intermediate layer covers a surface of the second insulation layer, the second bonding intermediate layer is provided with an opening, and the second metal layer is exposed to a surface of the second bonding intermediate layer through the opening on the second bonding intermediate layer. A material of the second bonding intermediate layer includes a material that can form a dangling bond by removing an oxide layer on the surface, and the second surface includes an exposed surface of the second bonding intermediate layer and an exposed surface of the second metal layer. The surface activation processing includes removing an oxide layer on the surface of the second metal layer and an oxide layer on the surface of the second bonding intermediate layer.

In this embodiment, the exposed surface of the second bonding intermediate layer 202-3 and the exposed surface of the second metal layer 202-2 are used to perform hybrid bonding with the first chip.

It is noted herein that, when surface activation processing is performed on the first chip and the second chip, atmospheric pressure of the vacuum environment may be less than 10⁻⁴ Pa (Pa). For surface activation processing, for example, a surface may be physically bombarded by using an argon ion beam or an atomic beam, to remove the native oxide layer on the first surface and a native oxide layer on the second surface. For a specific implementation process, refer to descriptions in a related technology. Details are not described herein again.

S711: Align, with the second surface on which surface activation processing has been performed and that is of the second chip, the first surface on which surface activation processing has been performed and that is of the first chip.

For implementation of this step, refer to descriptions in a related technology. Details are not described herein again.

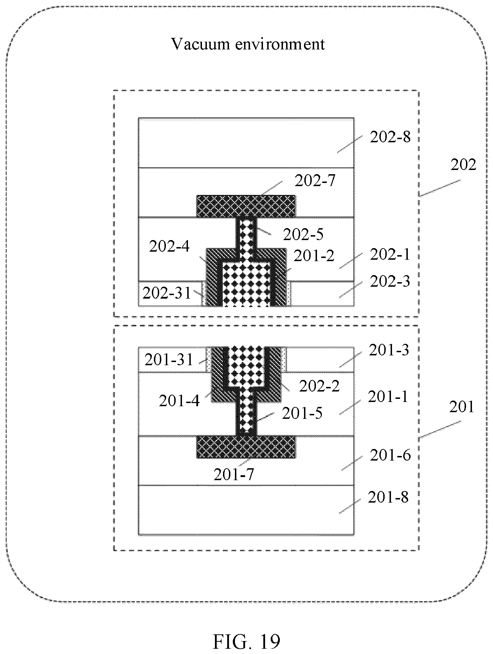

An exemplary diagram of a structure of aligning the first surface with the second surface is shown in FIG. 19.

S712: Apply pressure to the first chip and the second chip, to enable the first metal layer 201-2 to be bonded with the second metal layer 202-2, and enable the first bonding intermediate layer 201-3 to be bonded with the second bonding intermediate layer 202-3.

In this embodiment of this application, the first metal layer 201-2 is directly bonded with the second metal layer 202-2, and the first insulation layer 201-1 is bonded with the second insulation layer 202-1 through the first bonding intermediate layer 201-3 and the second bonding intermediate layer 202-3.

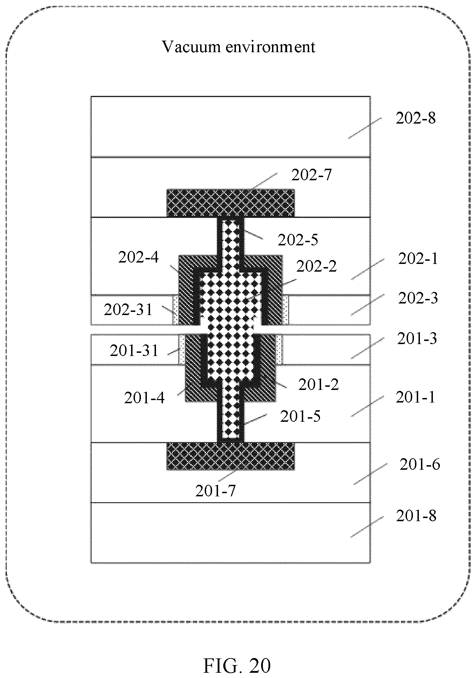

In a possible implementation, when the first surface is bonded with the second surface, the corresponding first metal layer 201-2 may be in contact with the second metal layer 202-2 first, as shown in FIG. 20. Then, under specific pressure, the first bonding intermediate layer 201-3 is bonded with the second bonding intermediate layer 202-3 through plastic deformation that occurs in a bonding process of the first metal layer 201-2 and the second metal layer 202-2.

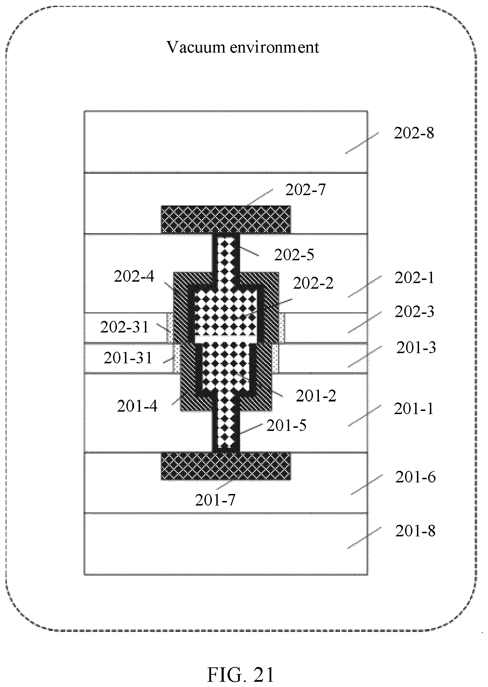

In another possible implementation, when the first surface is bonded with the second surface, the first bonding intermediate layer 201-3 may alternatively be in contact with the second bonding intermediate layer 202-3 first, as shown in FIG. 21. A gap is reserved between the first metal layer 201-2 and the second metal layer 202-2, and then the first metal layer 201-2 and the second metal layer 202-2 may be expanded through thermal treatment, so that the two layers are in contact and the first metal layer 201-2 can be bonded with the second metal layer 202-2. In addition, because the thermal treatment may further enable metal grains on both sides of a metal bonding surface to grow, a resistance of the bonding surface may be further reduced.

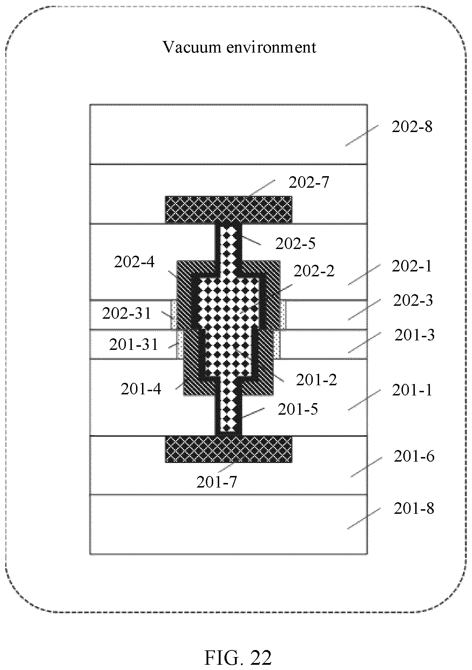

An example diagram of a structure obtained after hybrid bonding is performed on the first chip and the second chip is shown in FIG. 22.

According to the semiconductor apparatus manufacturing method provided in embodiments of this application, the first metal layer 201-2 of the first chip can be directly bonded with the second metal layer 202-2 of the second chip, or the first insulation layer 201-3 is connected to the second insulation layer 202-3 through the first bonding intermediate layer 201-3 of the first chip and the second bonding intermediate layer 202-3 of the second chip.

It is noted herein that embodiments of this application merely show an example of a manufacturing method for obtaining a semiconductor apparatus from two chips. The manufacturing method may also be applied to a semiconductor apparatus obtained by stacking a plurality of layers of a plurality of chips, for example, a semiconductor apparatus obtained by performing hybrid bonding on a front surface and a front surface of a chip and on a front surface and a back surface. This is not limited in embodiments of this application.

It should be understood that the term "and/or" in this specification describes only an association relationship between associated objects and represents that three relationships may exist. For example, A and/or B may represent the following three cases: Only A exists, both A and B exist, and only B exists. A and B may be singular or plural. In addition, the character "/" in this specification usually indicates an "or" relationship between the associated objects, but may also indicate an "and/or" relationship. For details, refer to the context for understanding.

In this application, "at least one" means one or more, and "a plurality of" means two or more. "At least one of the following items (pieces)" or a similar expression thereof refers to any combination of these items, including any combination of singular items (pieces) or plural items (pieces). For example, at least one (piece) of a, b, or c may indicate: a, b, c, a and b, a and c, b and c, or a, b, and c, where a, b, and c may be singular or plural.

It should be understood that sequence numbers of the foregoing processes do not mean execution sequences in various embodiments of this application. The execution sequences of the processes should be determined based on functions and internal logic of the processes, and should not be construed as any limitation on the implementation processes of embodiments of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor apparatus, comprising a first chip and a second chip, wherein
the first chip comprises a first bonding intermediate layer (201-3) and a first metal layer (201-2), the first bonding intermediate layer (201-3) is provided with an opening, and the first metal layer (201-2) is exposed to a surface of the first bonding intermediate layer (201-3) through the opening on the first bonding intermediate layer (201-3);
the second chip comprises a second bonding intermediate layer (202-3) and a second metal layer (202-2), the second bonding intermediate layer (202-3) is provided with an opening, and the second metal layer (202-2) is exposed to a surface of the second bonding intermediate layer (202-3) through the opening on the second bonding intermediate layer (202-3);
materials of the first bonding intermediate layer (201-3) and the second bonding intermediate layer (202-3) each comprise a material that can form a dangling bond by removing an oxide layer on the surface; and
the first bonding intermediate layer (201-3) is bonded with the second bonding intermediate layer (202-3), and the first metal layer (201-2) is bonded with the second metal layer (202-2).

2. The semiconductor apparatus according to claim 1, wherein the first bonding intermediate layer (201-3) is located on an active surface of the first chip, and the second bonding intermediate layer (202-3) is located on an active surface of the second chip.

3. The semiconductor apparatus according to claim 1 or 2, wherein a first sidewall insulation layer (201-31) is disposed between the first bonding intermediate layer (201-3) and the first metal layer (201-2), a second sidewall insulation layer (202-31) is disposed between the second bonding intermediate layer (202-3) and the second metal layer (202-2), the first sidewall insulation layer (201-31) is an oxide insulation layer or a nitride insulation layer formed by the first bonding intermediate layer (201-3), and the second sidewall insulation layer (202-31) is an oxide insulation layer or a nitride insulation layer formed by the second bonding intermediate layer (202-3).

4. The semiconductor apparatus according to claim 3, wherein a first isolating layer (201-4) is disposed between the first metal layer (201-2) and the first sidewall insulation layer (201-31), a second isolating layer (202-4) is disposed between the second metal layer (202-2) and the second sidewall insulation layer (202-31), and materials of the first isolating layer (201-4) and the second isolating layer (202-4) are insulating materials.

5. The semiconductor apparatus according to claim 4, wherein the material of the first isolating layer (201-4) or the second isolating layer (202-4) comprises any one of the following: silicon dioxide, silicon nitride, silicon oxynitride, silicon carbon nitride, aluminum oxide, and silicon oxycarbide.

6. The semiconductor apparatus according to claim 4 or 5, wherein the semiconductor apparatus further comprises a first insulation layer (201-1), a second insulation layer (202-1), a third insulation layer (201-6), a fourth insulation layer (202-6), a first metal wiring layer (201-7), a second metal wiring layer (202-7), a first diffusion barrier layer (201-5), and a second diffusion barrier layer (202-5);
the first metal wiring layer (201-7) is located in a groove of the third insulation layer (201-6), the first insulation layer (201-1) covers a surface of the third insulation layer (201-6) and covers one part of a surface of the first metal wiring layer (201-7), and the diffusion barrier layer (201-5) is disposed on the other part of the surface of the first metal wiring layer (201-7), disposed between the first insulation layer (201-1) and the first metal layer (201-2), and disposed between the first metal layer (201-2) and the first isolating layer (201-4); and
the second metal wiring layer (202-7) is located in a groove of the fourth insulation layer (202-6), the second insulation layer (202-1) covers a surface of the fourth insulation layer (202-6) and covers one part of a surface of the second metal wiring layer (202-7), and the diffusion barrier layer (202-5) is disposed on the other part of the surface of the second metal wiring layer (202-7), disposed between the second insulation layer (202-1) and the second metal layer (202-2), and disposed between the second metal layer (202-2) and the second isolating layer (202-4).

7. The method according to claim 6, wherein the semiconductor apparatus further comprises a first semiconductor substrate (201-8) and a second semiconductor substrate (202-8), the third insulation layer (201-6) covers a surface of the first semiconductor substrate (201-8), and the fourth insulation layer (202-6) covers a surface of the second semiconductor substrate (202-8).

8. The semiconductor apparatus according to any one of claims 1 to 7, wherein thicknesses of the first bonding intermediate layer (201-3) and the second bonding intermediate layer (202-3) fall within a range of 5 nanometers to 500 nanometers.

9. The semiconductor apparatus according to any one of claims 1 to 8, wherein the material of the first bonding intermediate layer (201-3) or the second bonding intermediate layer (202-3) comprises any one of the following: silicon, silicon carbide, germanium, and aluminum nitride.

10. A semiconductor apparatus, comprising a first chip and a second chip, wherein
the first chip comprises a first bonding intermediate layer (201-3) and a first metal layer (201-2), the first bonding intermediate layer (201-3) is provided with an opening, and the first metal layer (201-2) is exposed to a surface of the first bonding intermediate layer (201-3) through the opening on the first bonding intermediate layer (201-3);
the second chip comprises a second bonding intermediate layer (202-3) and a second metal layer (202-2), the second bonding intermediate layer (202-3) is provided with an opening, and the second metal layer (202-2) is exposed to a surface of the second bonding intermediate layer (202-3) through the opening on the second bonding intermediate layer (202-3);
materials of the first bonding intermediate layer (201-3) and the second bonding intermediate layer (202-3) each comprise any one of the following: silicon, silicon carbide, aluminum nitride, and germanium; and
the first bonding intermediate layer (201-3) is bonded with the second bonding intermediate layer (202-3), and the first metal layer (201-2) is bonded with the second metal layer (202-2).

11. A semiconductor apparatus manufacturing method, comprising:
performing surface activation processing on a first surface of a first chip in a vacuum environment, wherein the first chip comprises a first insulation layer (201-1), a first metal layer (201-2), and a first bonding intermediate layer (201-3), the first metal layer (201-2) is located in a groove of the first insulation layer (201-1), the first bonding intermediate layer (201-3) covers a surface of the first insulation layer (201-1), the first bonding intermediate layer (201-3) is provided with an opening, the first metal layer (201-2) is exposed to a surface of the first bonding intermediate layer (201-3) through the opening on the first bonding intermediate layer (201-3), a material of the first bonding intermediate layer (201-3) comprises a material that can form a dangling bond by removing an oxide layer on the surface, the first surface comprises an exposed surface of the first bonding intermediate layer (201-3) and an exposed surface of the first metal layer (201-2), and the surface activation processing comprises removing an oxide layer on the surface of the first metal layer (201-2) and an oxide layer on the surface of the first bonding intermediate layer (201-3);
performing surface activation processing on a second surface of a second chip in the vacuum environment, wherein the second chip comprises a second insulation layer (202-1), a second metal layer (202-2), and a second bonding intermediate layer (202-3), the second metal layer (202-2) is located in a groove of the second insulation layer (202-1), the second bonding intermediate layer (202-3) covers a surface of the second insulation layer (202-1), the second bonding intermediate layer (202-3) is provided with an opening, the second metal layer (202-2) is exposed to a surface of the second bonding intermediate layer (202-3) through the opening on the second bonding intermediate layer (202-3), a material of the second bonding intermediate layer (202-3) comprises a material that can form a dangling bond by removing an oxide layer on the surface, the second surface comprises an exposed surface of the second bonding intermediate layer (202-3) and an exposed surface of the second metal layer (202-1), and the surface activation processing comprises removing an oxide layer on the surface of the second metal layer (202-2) and an oxide layer on the surface of the second bonding intermediate layer (202-3);
aligning, with the second surface on which surface activation processing has been performed and that is of the second chip, the first surface on which surface activation processing has been performed and that is of the first chip; and
applying pressure to the first chip and the second chip, to enable the first metal layer (201-2) to be bonded with the second metal layer (202-2), and enable the first bonding intermediate layer (201-3) to be bonded with the second bonding intermediate layer (202-3).

12. The method according to claim 11, wherein before the performing surface activation processing on a first surface of a first chip in a vacuum environment, the method further comprises:
manufacturing the first bonding intermediate layer (201-3) on the surface of the first insulation layer (201-1) of a first initial apparatus;
manufacturing a groove on the first bonding intermediate layer (201-3) and the first insulation layer (201-1);
manufacturing the first metal layer (201-2) in the groove; and
removing all layers on the first bonding intermediate layer (201-3) to expose the surface of the first bonding intermediate layer (201-3), to obtain the first chip.

13. The method according to claim 12, wherein before the manufacturing the first metal layer (201-2) in the groove, the method further comprises:
forming a first sidewall insulation layer (201-31) on the surface of the first bonding intermediate layer (201-3) and between the first bonding intermediate layer (201-3) and the first metal layer (201-2).

14. The method according to claim 12 or 13, wherein the exposed surface of the first metal layer (201-2) is higher than the exposed surface of the first bonding intermediate layer (201-3).

15. The method according to any one of claims 12 to 14, wherein the manufacturing a groove on the first bonding intermediate layer (201-3) and the first insulation layer (201-1) comprises:
manufacturing a first groove on the first bonding intermediate layer (201-3), wherein a depth of the first groove is equal to or greater than a thickness of the first bonding intermediate layer (201-3);
manufacturing a first isolating layer (201-4) on a surface of the first groove;
opening a bottom surface of the first groove; and
manufacturing a second groove in the first insulation layer (201-1).

16. The method according to any one of claims 12 to 15, wherein the first initial apparatus further comprises a third insulation layer (201-6) and a first metal wiring layer (201-7), the first metal wiring layer (201-7) is located in a groove of the third insulation layer (201-6), and the first insulation layer (201-1) covers the third insulation layer (201-6) and the first metal wiring layer (201-7), wherein
the second groove manufactured in the first insulation layer (201-1) penetrates the first insulation layer (201-1), and the first metal wiring layer (201-7) is exposed.

17. The method according to claim 16, wherein before the manufacturing the first metal layer (201-2) in the groove, the method further comprises:
manufacturing a first diffusion barrier layer (201-5) on the surface of the first groove and a surface of the second groove.

18. The method according to any one of claims 11 to 17, wherein the material of the first bonding intermediate layer (201-3) or the second bonding intermediate layer (202-3) comprises any one of the following: silicon, silicon carbide, germanium, and aluminum nitride.
